# EUROPEAN PATENT APPLICATION

(11) **EP 2 775 622 A1**
(43) Date of publication of application: **10.09.2014**
(21) Application number: 14157558.9
(22) Date of filing: 04.03.2014
(51) Int. Cl.: H03K 17/693, H04B 1/48, H03K 17/06

(54) **RF switch gate control**

(30) Priority: 06.03.2013 US 201361773599 P; 03.03.2014 US 201414195511
(71) Applicant: International Rectifier Corporation, El Segundo, CA 90245 (US)
(72) Inventor: Briere, Michael A., Scottsdale, AZ Arizona 85266 (US)
(74) Representative: Dr. Weitzel & Partner

(57) **Abstract**

In one implementation, a switching circuit 300 includes a pass switch 306a, 306b, including group III-V, for example III-Nitride, transistors coupled between an input 302a, 302b, of the switching circuit and an output 304 of the switching circuit. The switching circuit further includes a shunt switch 326a, 326b,configured to ground the input of the switching circuit while the pass switch is disabled. The switching circuit also includes a gate control transistor 310a, 310b, 340a, 340b configured to reduce resistance between a control terminal of the pass switch and/or the shunt switch and gate of the group III-V transistor of the pass switch and/or the shunt switch so as to enable and disable the pass switch and/or shunt switch. The gate control transistor can be coupled across a gate resistor 312a, 312b, 31c, 312d of the pass switch and/or the shunt switch. The gate control transistor can reduce the resistance in order to lower the OFF state impedance of the pass switch and/or the shunt switch.

## Description

### BACKGROUND

The present application claims the benefit of and priority to U.S. Provisional Patent Application Ser. No. 61/773,599, filed on March 6, 2013, and entitled "RF Switch Gate Control." The disclosure of this provisional application is hereby incorporated fully by reference into the present application.

### I. DEFINITION

As used herein, the phrase "group III-V" refers to a compound semiconductor including at least one group III element and at least one group V element. By way of example, a group III-V semiconductor may take the form of a III-Nitride semiconductor. "III-Nitride" or "III-N" refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. III-Nitride also refers generally to any polarity including but not limited to Ga-polar, N-polar, semi-polar, or non-polar crystal orientations. A III-Nitride material may also include either Wurtzitic, Zincblende, or mixed polytypes, and may include single-crystal, monocrystalline, polycrystalline, or amorphous structures. Gallium nitride or GaN, as used herein, refers to a III-Nitride compound semiconductor wherein the group III element or elements include some or a substantial amount of gallium, but may also include other group III elements in addition to gallium. A group III-V or a III-Nitride transistor may also refer to a composite high voltage enhancement mode transistor that is formed by connecting the group III-V or the III-Nitride transistor in cascode with a lower voltage group IV transistor.

In addition, as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates such as silicon on insulator (SOI), separation by implantation of oxygen (SIMOX) process substrates, and silicon on sapphire (SOS), for example.

It is noted that, as used herein, the terms "low voltage" or "LV" in reference to a transistor or switch describe a transistor or switch with a voltage range of up to approximately fifty volts (50V). It is further noted that use of the term "midvoltage" or "MV" refers to a voltage range from approximately fifty volts to approximately two hundred volts (approximately 50V-200V). Moreover, the term "high voltage" or "HV," as used herein, refers to a voltage range from approximately two hundred volts to approximately twelve hundred volts (approximately 200V-1200V), or higher.

### II. BACKGROUND ART

Group III-V heterostructure field-effect transistors (group III-V HFETs), such as group III-V high electron mobility transistors (group III-V HEMTs), may be employed in switching circuits. For example, it may be suitable to utilize group III-V HFETs as radio frequency (RF) switches in switching circuits for wireless communication applications.

In wireless communication applications, performance of RF switches can be quantified by parameters including insertion loss, linearity and switch isolation. Insertion loss can be measured as a difference between maximum available power at an input of an RF switch and power at an output of the RF switch. When the RF switch is implemented utilizing a transistor, such as a group III-V HFET, on-resistance of the transistor, as well as parasitic resistances of the transistor, contribute to insertion loss. Switch isolation can be measured as an amount of power reaching an output of an RF switch when the RF switch is in an OFF state.

### SUMMARY

An RF switch with gate control for use in RF switching circuits, substantially as shown in and/or described in connection with at least one of the figures, and as set forth more completely in the claims.

### BRIEF DESCRIPTION OF THE DRAWINGS

Figure 1 is a simplified electrical schematic of a known single pole double throw (SPDT) RF switch.
Figure 2 shows another simplified electrical schematic of a known single pole double throw (SPDT) RF switch using serise connected transistors.
Figure 3 shows an exemplary circuit schematic of a switching circuit, according to an implementation disclosed in the present application.

### DETAILED DESCRIPTION

The following description contains specific information pertaining to various implementations in the present disclosure. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

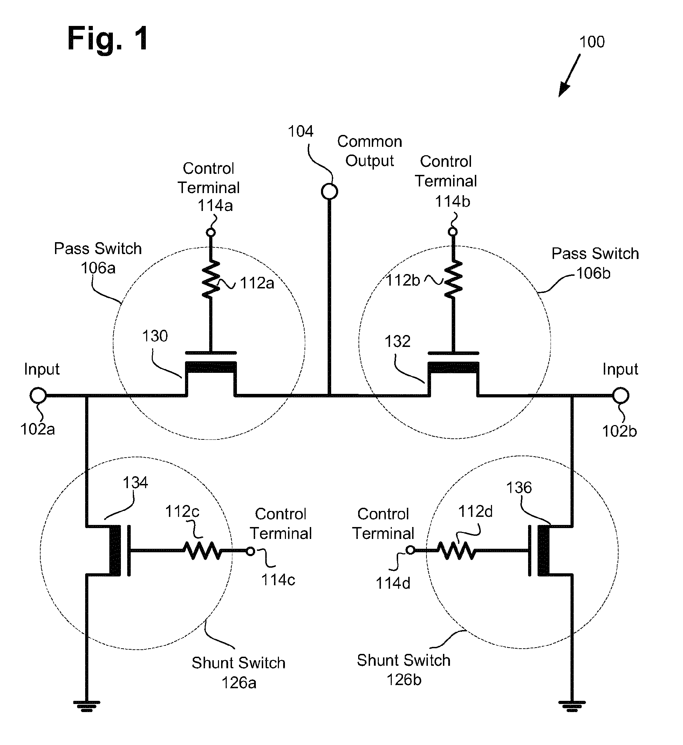

Figure 1 shows a simplified circuit schematic of a single pole double throw (SPDT) RF switch. This configuration is widely used in RF application fields. In particular, Figure 1 shows switching circuit 100, which includes pass switches 106a and 106b, shunt switches 126a and 126b, inputs 102a and 102b, and output 104.

Pass switch 106a includes transistor 130, gate resistor 112a, and control terminal 114a. Similarly, pass switch 106b includes transistor 132, gate resistor 112b, and control terminal 114b. Shunt switch 126a includes transistor 134, gate resistor 112c, and control terminal 114c. Similarly, shunt switch 126b includes transistor 136, gate resistor 112d, and control terminal 114d.

In pass switch 106a, transistor 130 is coupled between input 102a of switching circuit 100 and common output 104 of switching circuit 100. In pass switch 106b, transistor 132 is coupled between input 102b of switching circuit 100 and common output 104 of switching circuit 100. Thus, output 104 may serve as a common output of switching circuit 100. Shunt switch 126a is coupled between input 102a of switching circuit 100 and ground. Also, shunt switch 126b is coupled between input 102b of switching circuit 100 and ground.

Control terminal 114a is configured to enable and disable pass switch 106a, and control terminal 114b is configured to enable and disable pass switch 106b. Similarly, control terminal 114c is configured to enable and disable shunt switch 126a, and control terminal 114d is configured to enable and disable shunt switch 126b.

Pass transistors 130 and 132, as well as shunt transistors 134 and 136 have been implemented in different semiconductor technologies including group III-V technologies (e.g., GaAs and III-Nitrides) and complemtary-metal-oxide-semiconductor (CMOS) and laterally-diffused-metal-oxide-semiconductor (LDMOS) technology. Transistors 130, 132, 134 and 136 have also been implemented in both depletion-mode (D-mode) as well as enhancement mode (E-mode) device architectures. The choice of semiconductor technology used results in varying degrees of performance. Some of the important characteristics of the transistor design for RF applications include the ON state resistance (Ron) and the OFF state capacitance (Coff). These two parameters need to be minimized in order to achieve both low insertion loss and high isolation.

Another important design feature used to improve insertion losses for transistors used in RF switch circuits is the use of gate resistors as shown in circuit 100 as elements 112a, 112b, 112c and 112d. The gate resistors are used to isolate the DC gate control from the RF path, which isaccomplished by placing a resistor in series with the gate for the transistor. When large resistence values are used (e.g., greater than 30 kilo-ohms for example) the gate resistors improve the ON state performance of the switch in terms of insertion loss by reducing the modulation of the switch resistance due to the induced variation in gate-terminal potential when the terminal potential is modulated with respect to ground. Unfortunately, the presence of a large resister between the gate and the control terminal prevent robust isolation between the terminals across the gate while in the OFF state, because the gate of the switch is not strongly tied to a given "off" potential.

For example, in circuit designs where the pass and shunt transistors are depletion mode transistors, the larger resistance values between the corresponding control terminals 114a, 114b, 114c, 114d, and the gate of respective depletion mode switches 130, 132, 134 and 136 can interfere with the ability of the corresponding control terminals 114a, 114b, 114c, and 114d to disable their respective transistors 130, 132, 134 and 136. For example, gate resistor 112a can interfere with the ability of control terminal 114a to disable depletion mode transistor 130. In the present implementation, the resistance can be greater than, for example, approximately 30 kilo-ohms. For example, gate resistors 112a, 112b, 112c, and 112d can each have a resistance greater than, for example, approximately 30 kilo-ohms. As such, it can be difficult to hold the gate of the respective depletion mode transistors 130, 132, 134 and 136 in a disabled, or nominally OFF state, resulting in the transmission of a fraction of the modulated voltage of one of the terminals of a switch, e.g. pass switch 106b, to the other terminal, thereby reducing the performance of RF switch 100, through reduced isolation characteristics.

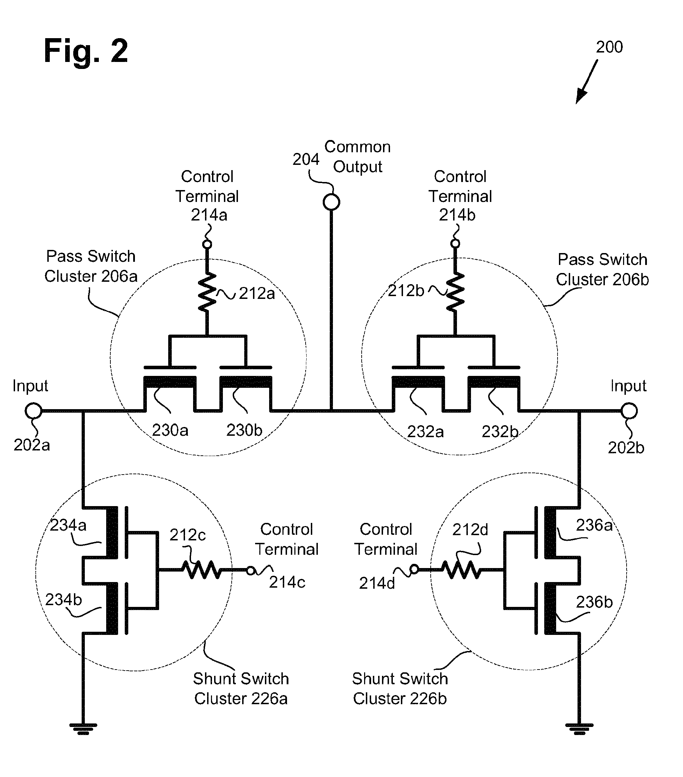

As a compromise, it is presently known to use multiple series connected switches (i.e. gate stacked transistors), reducing the gate-source modulation of the second (and further) switch(s) in the ON state while providing better isolation in the OFF state by holding the gate more strongly tied to the gate driver using a modest resistor value, for example 20 kilo-ohms. An example of an RF circuit employing such a gate stacking design is shown in Figure 2.

Figure 2 shows switching circuit 200, which includes pass switch clusters 206a and 206b, shunt switch clusters 234a and 234b, inputs 202a and 202b, and common output 204. Pass switch cluster 206a includes transistor 230a and 230b, gate resistor 212a, and control terminal 214a. Similarly, pass switch cluster 206b includes transistor s 232a and 232b, gate resistor 212b, and control terminal 214b. Shunt switch cluster 226a includes transistors 234a and 234b, gate resistor 212c, and control terminal 214c. Similarly, shunt switch cluster 226b includes transistors 236a and 236b, gate resistor 212d, and control terminal 214d.

In pass switch cluster 206a, transistors 230a and 230b are series connected. This configuration is commonly referred to as a gate stacked configuration and Figure 2 shows pass switch clusters 206a and 206b, as well as shunt switch clusters 226a and 226b having two series connected transistors. However it is understood that more than two series connected transistors can be used in a gate stacked configuration. As mentioned earlier, the gate stacked transistors may be group III-V transistors, or may be CMOS or LDMOS transistors. The gate stacked transistors 230a and 230b are coupled between input 202a of switching circuit 200 and common output 204 of switching circuit 200. In pass switch cluster 206b, gate stacked transistors 232a and 232b are coupled between input 202b of switching circuit 200 and common output 204 of switching circuit 200. Thus, output 204 may serve as a common output of switching circuit 200. Shunt switch cluster 226a is coupled between input 202a of switching circuit 200 and ground. Also, shunt switch cluster 226b is coupled between input 202b of switching circuit 200 and ground.

Control terminal 214a is configured to enable and disable pass switch cluster 206a, and control terminal 214b is configured to enable and disable pass switch cluster 206b. Similarly, control terminal 214c is configured to enable and disable shunt switch cluster 226a, and control terminal 214d is configured to enable and disable shunt cluster switch 226b.

Unfortunately, even in the RF switch circuit design such as that described in Figure 2, the use of gate stacked transistors in combination with a large resistor between the control terminal and the gates of the gate stacked transistors are still subject to the drawbacks described above. As mentioned previously, in the case where depletion mode group III-V or III-N field effect transistors (FETs) or high electron mobility transistors (HEMTs) are used as the transistors in the RF switch clusters, in order to turn the RF switch cluster off, a bias needs to be applied to the gates of the transistors. Referring to Figure 2, when RF pass switch cluster 206a is turned off, RF shunt switch cluster 226a is turned on and the RF input from 202a is shunted to ground and isolated from the common RF output 204. Since transistors 230a and 230b in pass switch cluster 206a are depletion mode transistors, a control signal is applied to the gates of the transistors to turn them off. In the OFF state, there is less concern about coupling of the DC and RF signals; however, the concerns associated with RF switch isolation remain. Since the depletion mode transistors in the clusters are coupled to the gate controller through a relatively high gate resistor (e.g., 20 kilo-ohms or more) it is difficult to completely hold the gates off in the OFF state.

The presently disclosed inventive concepts and their various implementations enable a significantly improved performance of the RF switch arrangement by providing a large gate resistor in the ON state, enabling good linearity and low transmission loss and near zero gate resistance in the OFF state, providing a high degree of isolation between the switch terminals across the gate. According to the present inventive concepts and its various implementations, these advantages are accomplished through the addition of a switch across the gate resistors which is turned on when the RF switch is off and turned off when the RF switch is on. It is also provided in the present disclosure that the use of P channel transistors as the active gate shunting switches, together with depletion mode III-Nitride RF switches, allows for advantageous control circuitry. Furthermore, the present disclosure provides for the integration of two or more components of this RF switch.

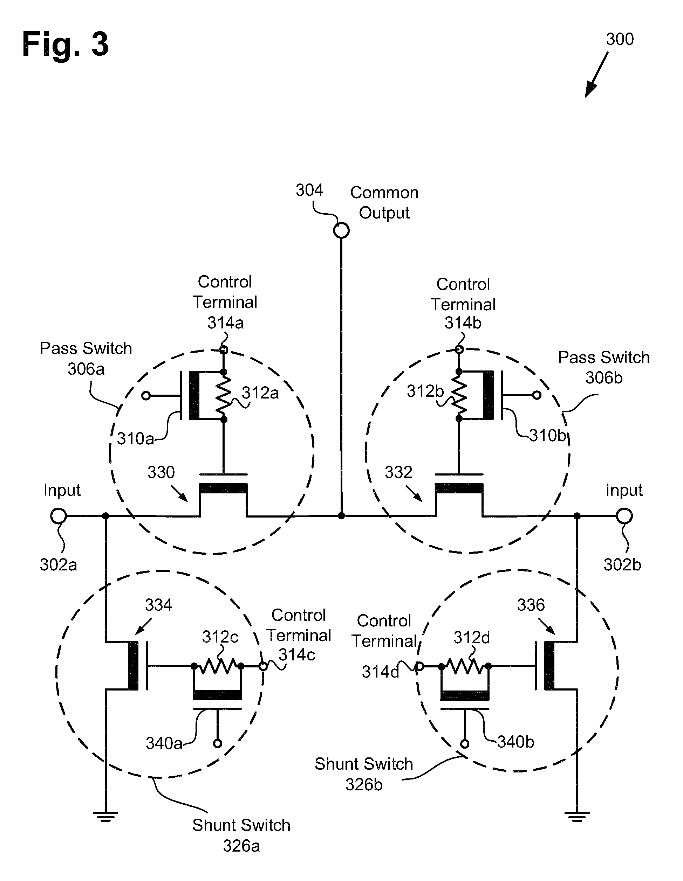

Referring now to Figure 3, Figure 3 shows an exemplary circuit schematic of a switching circuit, according to an implementation disclosed in the present application. In particular, Figure 3 shows switching circuit 300 corresponding to switching circuit 100 in Figures 1. Switching circuit 300 includes pass switches 306a and 306b, shunt switches 326a and 326b, inputs 302a and 302b, and common output 304 corresponding respectively to pass switches 106a and 106b, shunt switches 126a and 126b, inputs 102a and 102b, and common output 104 in switching circuit 100.

Pass switch 306a includes gate control transistor 310a, as well as gate resistor 312a, and control terminal 314a corresponding respectively to gate resistor 112a, and control terminal 114a in pass switch 106a. Similarly, pass switch 306b includes gate control transistor 310b, as well as gate resistor 312b and control terminal 314b corresponding respectively to gate resistor 112b and control terminal 114b in pass switch 106b. Shunt switch 326a includes gate control transistor 340a, as well as gate resistor 312c and control terminal 314c corresponding respectively to gate resistor 112c and control terminal 114c of shunt switch 126a in switching circuit 100. Similarly, shunt switch 326b includes gate control transistor 340b, as well as a gate resistor 312d and control terminal 314d corresponding respectively to gate resistor 112d and control terminal 114d in shunt switch 126b in switching circuit 100.

Figure 3 illustrates an implementation where switching circuit 300 includes group III-V transistors 330, 332, 334 and 336 corresponding respectively to transistors 130, 132, 134 and 136 of switching circuit 100. In some implementations, transistors 330, 332, 334 and 336 are depletion mode group III-V transistors. It is noted that in other implementations, transistors 330, 332, 334 and 336 may be CMOS or LDMOS transistors. Thus, as described with respect to Figure 1 and Figure 2, implementations of the present disclosure provide for switching circuits in which at least one of a pass switches and/or shunt switches includes a gate control transistor configured to reduce resistance between a control terminal thereof, and a gate of a group III-V transistor thereof, so as to improve the RF performance in the OFF state of the switch. In addition, the ability to provide a low gate resistance in the OFF state through the gate control transistor allows for the use of a much larger gate resistor in the ON state, providing improved linearity and lower transmission loss. Thus, the use of the gate control transistor, for example, 310a, 310b, 340a and/or 340b, provides for improved performance of the RF switch in terms of reduced transmission loss and improved isolation.

In one implementation, the gate control transistor is coupled in parallel with the gate resistor to set the OFF state impedance low (for example, 1 to 2 ohms) and improve the RF isolation of the switch. For example, referring to Figure 3, III-Nitride transistor 330 of pass switch 306a is controlled by control terminal 314a through parallel connected gate resistor 312a and gate control transistor 310a. Similarly, III-Nitride transistor 332 of pass switch 306b is controlled by control terminal 314b through parallel connected gate resistor 312b and gate control transistor 310b. In a likewise fashion, III-Nitride transistor 334 of shunt switch 326a is controlled by control terminal 314c through parallel connected gate resistor 312c and gate control transistor 340a. Similarly, III-Nitride transistor 336 of shunt switch 326b is controlled by control terminal 314d through parallel connected gate resistor 312d and gate control transistor 340b.

According to some implementations, the gate control transistors comprise group IV transistors. In some implementations, it may be preferred that the gate control transistor is a P channel device with a threshold voltage of approximately-1.5V, or approximately the same as the pinch-off voltage of the depletion mode III-N transistor (-1V to -2.5V). However, in other implementations, the gate control transistor could be N channel device with either an inverter or a separate power supply.

In some implementations, it may be preferred to integrate the gate control transistor with the gate control resistor and/or monolithically integrate the III-V transistors with the gate control transistor and/or resistor on a common chip. It may be preferred to monolithically integrate some or all of the RF switch devices forming the RF pass or shunt transistors out of III-V material and forming the gate control transistors and/or resistors in the silicon body of a III-V-on-Si substrate. In yet other implementations, the gate control transistor and gate resistor could be replaced with a gate control transistor having a well-controlled OFF state resistance (for example, approxiamtely 20 kilo-ohms or higher).

In RF switch designs where it may be preferred to use two or more gate stacked III-V transistors, for example higher power RF switch designs which also require higher breakdown capability, the resulting pass switch clusters and shunt switch clusters may also be configured with a large gate resistor in the ON state, enabling good linearity and low transmission loss and near zero gate resistance in the OFF state, and providing a high degree of isolation between the switch terminals across the gate. As discussed above, these advantages are accomplished through the addition of a switch or gate control transistor in parallel with the gate resistors which is turned on when the RF switch is off and turned off when the RF switch is on.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described above, but many rearrangements, modifications, and substitutions are possible without departing from the scope of the present disclosure.

## Claims

1. An RF switch comprising:
at least one transistor;
a gate resistor and a gate control transistor;
wherein said gate control transistor is parallel connected across said gate resistor;
and wherein said gate control transistor is configured to reduce resistance between a control terminal of said RF switch and a gate of said at least one transistor when said at least one transistor is in an OFF state.

2. The RF switch of claim 1, wherein said gate resistor has a resistance greater than approximately 20 kilo-ohms.

3. The RF switch of claim 1, wherein said gate control transistor reduces said resistance to improve isolation of said RF switch.

4. The RF switch of claim 1, wherein said at least one transistor is a group III-V High Electron Mobility Transistor (HEMT).

5. The RF switch of claim 1, wherein said at least one transistor is a depletion mode transistor.

6. The RF switch of claim 1, wherein said at least one transistor is selected from the group consisting of a CMOS transistor and a LDMOS transistor.

7. The RF switch of claim 1, wherein said gate control transistor is a P channel transistor.

8. The RF switch of claim 1 wherein said at least one transistor comprises two or more series connected transistors.

9. The RF switch of claim 1, wherein said gate control transistor and said gate resistor are monolithically integrated.

10. The RF switch of claim 1, wherein one or more of said at least one transistors and either said gate control transistor and/or said gate resistor are monolithically integrated.

11. A switching circuit comprising:
a pass switch comprising at least one transistor coupled between an input of said switching circuit and an output of said switching circuit;
a shunt switch configured to ground said input of said switching circuit when said pass switch is disabled;
a gate control transistor configured to reduce resistance between a control terminal of said pass switch and gate of said at least one transistor of said pass switch so as to improve isolation of said pass switch.

12. The switching circuit of claim 11, wherein said gate control transistor is coupled across a gate resistor of said pass switch.

13. The switching circuit of claim 11, wherein said gate control transistor reduces said resistance to improve isolation of said switching circuit.

14. The switching circuit of claim 11, wherein said gate control transistor is a group IV transistor.

15. The switching circuit of claim 11, wherein said shunt switch comprises at least one group III-V transistor.
